**Europäisches Patentamt**

**European Patent Office**

**Office européen des brevets**

(19)

(11) **EP 1 564 643 A2**

(12) **EUROPEAN PATENT APPLICATION**

(43) Date of publication:
 **17.08.2005 Bulletin 2005/33**

(51) Int Cl.$^7$: **G06F 13/28**, G06F 17/50

(21) Application number: **04386004.8**

(22) Date of filing: **11.02.2004**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventor: **Fragiskos, Ieromnimon**<br>**19002 Peania, Athens (GR)** |
| (30) Priority: **11.02.2004 GR 2004100050** | (74) Representative: **Papataxiarchis, Panagiotis**<br>**Intracom S.A.,**<br>**Markopoulo Avenue 19, 5KM**<br>**19002 Peania - Athens (GR)** |
| (71) Applicant: **Intracom S.A. Hellenic Telecommunications & Electronics Industry**<br>**19002 Peania, Athens (GR)** | |

(54) **Synthesizable vhdl model of a multi-channel dma-engine core for embedded bus systems**

(57)     A synthesizable VHDL model of a multi-channel DMA-engine for use in embedded bus systems, called the Acorn DMA Engine is described. Said invention features a controller capable of interleaving up to 16 channels for data-transfers over a single 32-bit AHB bus, using a two-tier, programmable-priority, round-robin TDM algorithm. Single-block, multi-bock and scatter-gather transfers are supported and the DMA engine allows reprogramming and/or retriggering any of the 16 channels while other transfers are under way, without wait-states introduced onto the bus. Special circuitry is provided to minimize transfer-time of the 32-bit bus, even for addresses not aligned on 32-bit word boundaries, by automatically adjusting data-transfer size at every bus-cycle. IRQs are issued at transfer end, or to signal programming/runtime errors. IRQ-vectors that carry information associated with the interrupt are stored in either of two 8-entry queues, allowing the Acorn DMA Engine to continue operating even while other IRQ-vectors are still pending for service by the system host(s). The Acorn DMA Engine is supplied in the form of synthesizable VHDL code for incorporation into embedded/Soc designs. For attachment onto an AHB bus it requires the use of standard AHB master and slave interfaces.

Figure 2: The DMA-Engine's block-diagram. Note that the indicated "AHB Bus", "Slave Bus Interface & Address Decoder" and "Master Bus Interface" blocks are not the subject of this description and are not covered by this patent claim.

## Description

## BACKGROUND OF THE INVENTION

The present invention pertains to the field of embedded and System on a Chip (SoC) designs, and in particular to bus-based processor systems. It specifically concerns a synthesizable model of a Direct-Memory-Access or DMA-Engine written in the VHDL (Very High-Speed-Circuit Design Language) for incorporation in bus-based embedded systems and the realization of very high data-transfer rates across the system's bus (on the order of Gbit/sec) with a minimum of main processor involvement.

DMA engines are generally employed in bus-oriented computer systems, in order to perform transfers of data within system memory or between memory and I/O devices in an efficient manner, while at the same time offloading this simple repetitive task from the system's processor(s). DMA engines are typically configured as bus masters, which negotiate possession of the system bus with an arbiter. They usually offer the capability of programming a number of "channels" with the characteristics of individual memory-to-memory transfers, and of controlling the onset of these transfers.

Some examples of application fields for DMA-engines are PC motherboards, hard-disk controllers, file-servers, video-streaming, etc.

Embedded and SoC systems are constructed using ASIC of FPGA technology, whereby a single integrated circuit (IC) can incorporate a number of functional units such as processors, DMA-engines, memory & memory controllers, custom peripherals, etc. These functional units are typically interconnected by means of an internal on-chip bus, which offers an efficient, high-bandwidth path for data exchange between said units.

ASICs and FPGAs for embedded systems are frequently designed in the VHDL language, which offers a uniform framework for the development, modeling and circuit-level description of large systems, involving a number of complex subunits. VHDL (and similar languages, such as Verilog) is the method of choice for the timely and efficient development of large ASICs.

The synthesizable model of a Multi-Channel DMA-Engine described herein is delivered in a form that can be readily embedded into systems realized in ASICs or FPGAs and designed using the VHDL language. It offers multiple channel capability, with each channel individually programmable to perform a memory-transfer. Transfer types include single and multiple-block transfers, as well as so-called scatter-gather operations, consisting of lists of individual single- or multi-block memory transfers. Our present invention offers improved system dynamics, by having all channels serviced concurrently, by allocating time on the system-bus with a round-robin TDM algorithm. Based on the control features of our invention, channels can be dynamically reprogrammed and/or reactivated while other active channels are being serviced, without introducing interruptions to the data-transfers taking place over the bus. In addition, our invention adjusts data-transfer size over the bus automatically on a per-cycle basis, in order to minimize total transfer time, even for transferring data that is not aligned on maximum bus-width word boundaries. Completion of individual transfers or mis-programmed and aborted transfers may be notified by means of IRQ signaling to the system host(s).

The synthesizable model of a Multi-Channel DMA engine described herein is developed to interface with an AHB bus. AHB is the name given by ARM Ltd to a very-high performance, pipelined bus protocol, for use in embedded systems. It is a relatively simple, yet powerful protocol that allows the interconnection of multiple bus-masters with memory and peripherals over a high-bandwidth address-/data-path of user-definable dimensions. This DMA Engine has been designed for use with 32-bit AHB systems.

## SUMMARY OF THE INVENTION

The multi-channel DMA Engine described herein is designed to operate in a single 32-bit-bus AHB environment. Said DMA Engine is rendered in the VHDL hardware-description language, so that said DMA can be readily incorporated in bus-based systems that are similarly rendered in said language, for the purpose of rendering said systems in FPGAs or ASICs. Said DMA engine is called the Acorn DMA Engine, the name stemming from "Automatic Channel Order Rotation"; a method for multiplexing data-transfer activity between different channels that is a distinguishing characteristic of said DMA engine.

From this point onwards in this document, unless specifically indicated otherwise, any and all of the terms "Acorn DMA Engine", "DMA engine", "engine" shall be taken to mean "synthesizable VHDL model of the ACORN Direct-Memory-Access Engine". Also, for the purposes of this patent claim, any and all of the terms "host" and "processor" shall be taken to mean "embedded system processor", throughout this document.

The Acorn DMA Engine offers the following features:

- 16 channels for DMA transfers in hardware.
- Programmable transfer characteristics: source-/destination-address and length.
- Three transfer modes: Single-block, multiple-block and scatter-gather (list of individual single-/multi-block transfers).
- Multiple outstanding channel capability. Bus bandwidth is allocated to active channels with a round-robin TDM algorithm, on the basis of a programmable, two-tier priority scheme. It is possible to program and/or activate channels while the DMA Engine is busy servicing other channels. The new channel(s) are added to the active pool seamlessly, without introduction of wait-states or otherwise loss of performance. The round-robin TDM algorithm brings to the bus each active channel in strict succession, as defined by the channel's index, ranging from 0 to 15.

• Channels can be programmed to issue an interrupt to either of two system hosts at the end of a programmed transfer.

• Capability to address FIFOs or other types of I/O devices, which are mapped onto a unique system-address, but can still transmit/receive multiple data words. It is common to map an I/O device onto a single location inside the system's address-map. Data may be read from or written to that device by repetitively accessing that same address location. If the data to be transferred to/from the I/O device resides in another part of system memory, a channel of our DMA Engine can be appropriately programmed to transfer said data, just as if ordinary linear memory were to be accessed.

• The Acorn DMA will issue bus-cycles of size such that will minimize the required number of cycles to complete each transfer, by utilizing the maximum available data-bus width as soon as possible. This allows data transfers to/from non-word-aligned memory boundaries, without loss of performance.

• Single-block and multiple-block transfers are re-triggerable without requiring channel reprogramming. Scatter-gather transfers restartable with partial reprogramming.

• Transfers can be programmed to be triggered either by software executed by the system host(s), or by system slaves via dedicated trigger lines (non-bus signals). There is no automatic re-triggering of programmed transfers in either case.

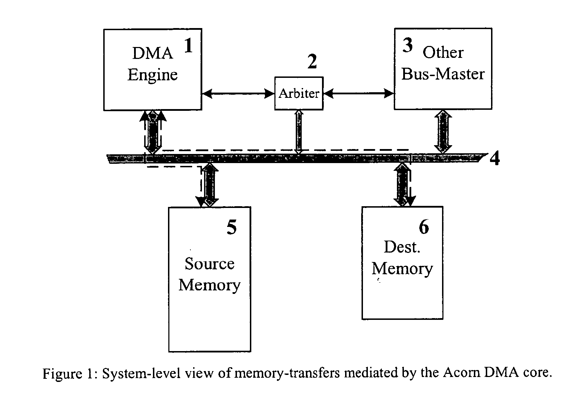

The Acorn features one AHB 32-bit Slave port, used by the system host(s) for channel programming/ triggering or diagnostic purposes, and one AHB 32-bit Master port, which is taking care of bus arbitration and control while the unit is servicing an active transfer. Figure 1 shows a model of memory transfers mediated by the Acorn DMA. In the figure, a single bus (4) is employed for channel programming and data-transfers. The DMA engine (1) is a bus-master, alongside another bus-master (3). The DMA negotiates possession of the bus with the Arbiter (2), which communicates with both bus masters. Once possession of the bus is granted to the DMA by the Arbiter, data is transferred from the Source (5) to the Destination Memory (6), which are attached to the bus as bus-slaves, i.e. passive devices that respond to read/write accesses by bus-masters.

Since the DMA Engine is attached to a single bus, memory transfers consist of two consecutive phases. During the read phase, data are read from the source address and stored in an internal buffer of limited size. During the following write phase, the stored data are written at the destination address. Thus, maximum data-transfer rate achievable by the Acorn DMA on a 32-bit AHB system is 2Mbytes/sec/MHz which is half the nominal bandwidth of a 32-bit AHB bus.

An example of a system comparable to our invention is described in patent number EPO WO0124015, referring to a multi-channel DMA controller, which features multiple read and write busses, but not transfer interleaving over a single address/data-bus, neither the notion of priority for channels, neither the capacity to minimize transfer-time irrespective of data-alignment in memory.

The system described in patent number US5870627 is also similar to our present invention. It refers to a "system for managing direct memory access transfer in a multi-channel system using circular descriptor queue, descriptor FIFO and receive status queue". The aforementioned system employs a pool of data-buffers consumed from- and returned to a circular queue by the individual programmed channels, thereby offering some scheduling mechanism, which is not explicitly defined. Said patent does not provide explicit channel interleaving, neither the notion of channel priority, transfer-time minimization or dynamic channel activation/removal.

Finally, patent number EP0486145 refers to "an improved multi-channel direct memory access (DMA) controller for data processing systems". Said system employs an algorithm for sharing the DMA controller's resources in order to service multiple channels, but not a TDM algorithm. Also, said patent does not cover channel priority, transfer-time minimization, or dynamic channel activation/removal.

## SUMMARY OF THE DRAWINGS

Figure 1 is an illustration of a data-transfer within a system that includes an Acorn DMA Engine (1), a system Arbiter (2), an additional Bus Master (3), single bus (4), a Source Memory (5) and a Destination Memory (6).

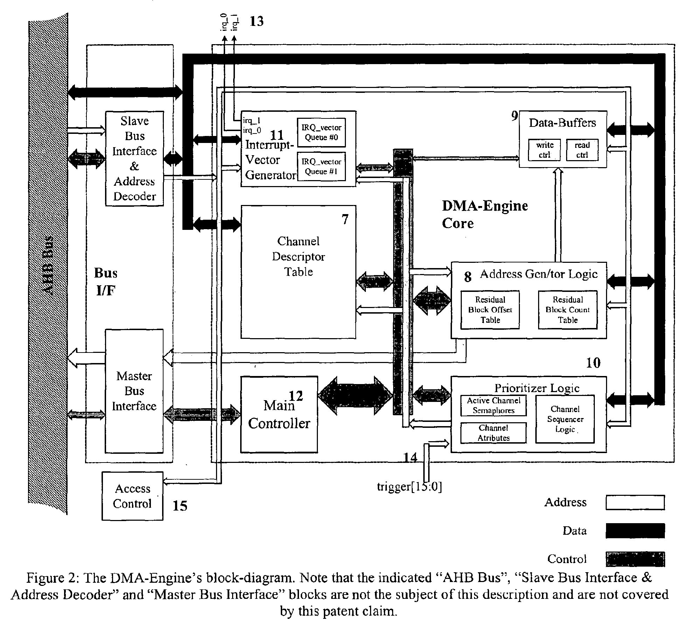

Figure 2 is a block diagram of the DMA Engine, indicating major functional blocks and their interconnection. The unit consists of a Channel Descriptor Table (7), an Address-Generator (8) that produces the memory-addresses placed on the system bus during transfers, a Data Buffer (9) for temporary storage of transferred data, a Prioritizer block (10) for channel management, an Interrupt-Vector Generator block (11) that queues IRQs addressed to two system processors able to handle interrupts and produces accordingly signals irq_0/irq_1 (13), a Main Controller (12) that is coordinating the above listed units and handshakes with the bus interface logic, 16 lines for peripheral (hardware)-controlled triggering of channels (14) and an Access-Control block (15).

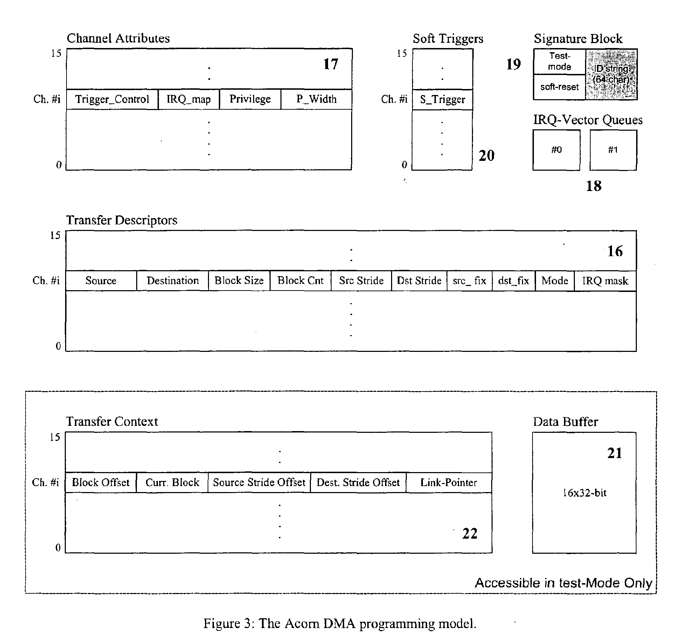

Figure 3 is a pictorial representation of the programming model of the Acorn DMA Engine, illustrating groups of logical entities required for programming the DMA Engine's functions as individual blocks. These groups are: the set of Transfer Descriptors (16), containing the programming of individual transfer characteristics, the set of Channel Attributes (17) that holds properties assigned to individual channels for the duration of the system's function, the two IRQ-Vector queues (18), with each queue entry holding a record of the conditions surrounding completion or abortion of a memory transfer, an Access Control block (19), which holds a product-identification string and mode-control registers, a set of soft-triggers (20) for software-controlled initiation of transfers, the temporary-storage Data-Buffer (21), also indicated by (9) and a set of Transfer-Context records (22), holding partial address-formation information associated with ongoing transfers.

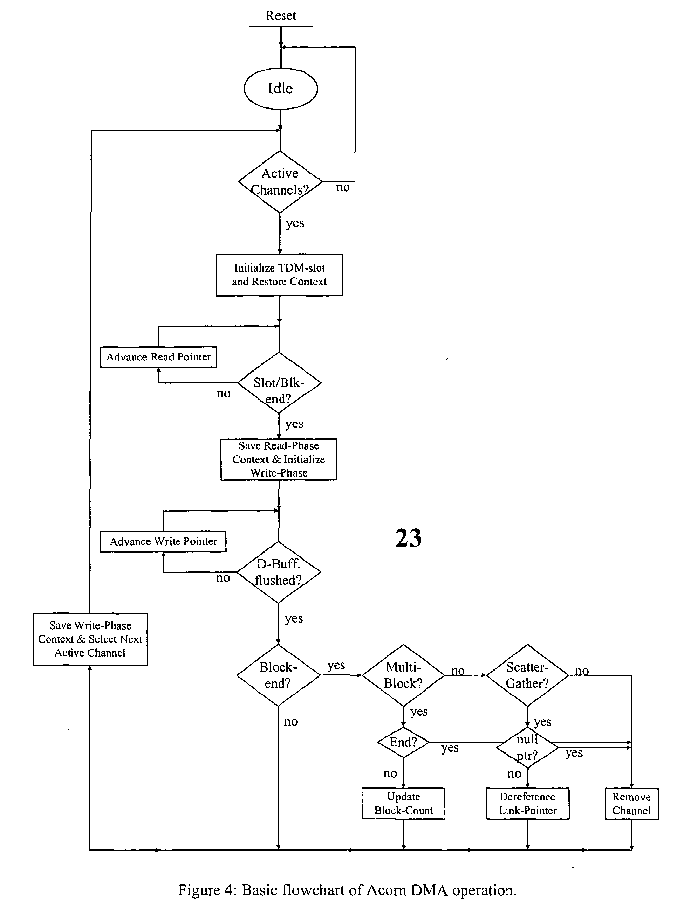

Figure 4 is a flow-chart description (23) of the DMA-Engine function. The operation of the round-robin TDM algorithm and the read/write phases associated with each stage of the algorithm are illustrated.

## DETAILED DESCRIPTION OF THE DRAWINGS.

The basic outline of the DMA-Engine's block diagram is shown in Figure 2. The system consists of the following parts, as follows:

- **The Channel Descriptor Table (7)** is a set of 16-entry arrays of registers that hold the descriptors associated with programmed transfers:

  □ 32-bit Source/destination address.
  □ Size and number of transferred block(s). A maximum size of 65,536 bytes per block and a maximum count of 255 blocks are allowed.
  □ Source- and destination-area block-stride (for multi-block transfers). Maximum stride length is 65536 bytes. Block-stride is the distance in memory between the start locations of consecutive memory-blocks in multi-block transfers. The block stride can be larger than the block length, thus allowing programmer-controlled gaps between multiple transferred blocks, either in the source or the destination memory area.
  □ Flags for selecting memory-mapped I/O devices as a source and/or destination for transferred data.
  □ Scatter-Gather transfer indicator flag.
  □ End-of-transfer IRQ-enable mask, enabling the queuing of an interrupt-vector at the end of a transfer (see below).

These register-arrays can be treated by the system programmer as a single logical group (16 in Figure 3), where each group of channel-descriptors is indexed by channel number, ranging from 0 to 15. The Channel Descriptor Table (7) also contains control logic in hardware that is required for the programming of the various array entries via the AHB slave interface.

- **The Address Generator Logic (8)** holds in 16-entry memory blocks the context associated with ongoing memory transfers, as follows:

  □ 16-by-8-bit block-count table, holding the number of individual blocks transferred so far.
  □ 16-by-16-bit block-offset table, holding an offset within the currently-transferred memory block.
  □ 16-by-24-bit source-stride and destination-stride-offset tables, holding the offset of the current block's start from the source and destination address respectively.
  □ 16-by-32-bit Link-pointers table. Each entry is a memory-pointer, attached to a data-record in system-memory, where the transfer-descriptors associated with the next memory-transfer are stored, in the course of scatter-gather transfers.

The above Address-Generator Logic tables are indexed by channel number (see item 21). They are employed for storing the above described address-formation information at the end of each TDM slot, so that it will be available for continuing the transfer when the TDM algorithm gives the bus again to the associated channel. The Address Generator Logic also contains hardware that employs said context information to generate the memory-addresses placed onto the system bus in order to perform the read/write cycles associated with each transfer.

- **The Data Buffer (9)** is a 4x16x8-bit SRAM, used for temporarily storing data read from the source memory area, before these data can be written to the destination memory-area. It is organized as a 512-byte FIFO queue that is written-to and read-from in strict order with data-words of size that varies between an 8-bit byte, a 16-bit word and a 32-bit long-word. This variable data-size feature allows for memory blocks to begin or end at address-locations that are not multiple of 4 bytes, which is the width of the 32-bit bus we are employing. A transfer of a non-aligned block would start by reading a single byte, followed perhaps by a 16-bit word read, or a single 16-bit word might be read first instead. After a maximum of two cycles with small-sized data transfers, all remaining data would be carried in units of 32-bits, until the whole block was moved, or less than 4 bytes remained to be transferred. In that case, up to two trailing bus cycles would be issued, to carry a 16-bit word and/or an 8-bit byte. Selection of data-transfer size is done automatically by the DMA-engine, without any wait-states introduced on the bus. In addition, the sizes of data read-out of the queue for writing onto the bus need not correspond to the sizes written into the queue while data was being read from the bus. Finally, the amount of data stored in the data buffer at any time cannot exceed 512 bytes. This is the largest amount of data that need be stored inside the DMA Engine at anytime during a maximum-priority transfer that is reading data from 32-bit aligned block boundaries.

- **The Prioritizer-Logic (10),** stores in a set of register-arrays the attributes for each of the 16 available channels as follows:

  □ 16-by-4-bit table of allocated TDM-slot width values, corresponding to channel-priority, from a range of 1 to 16. This is the number of consecutive read cycles, followed by as many write cycles, before the bus is hander over to the next "active" channel (see below). Note that the priority value assigned to each channel bears no relationship to its index, which ranges from 0 to 15, meaning that any indexed channel can be assigned any priority value.

  □ 16-by-1-bit table of privileged-access flags, indicating when set that the associated channel(s) are to be serviced to completion before other, non-privileged channels have the chance to go to the bus. This feature is called a two-tier priority scheme, because it segregates active channels in two groups: a privileged group of channels that shares the bus in round-robin TDM fashion until all channels have finished transferring data, and a non-privileged group that cannot start sharing the bus (again using the round-robin TDM algorithm) until all of the members of the former group have finished.

  □ 16-by-1-bit table of IRQ-mapping to either of two hosts. Each table entry directs the IRQ-vectors that may be generated by the channel at the appropriate IRQ-vector queue indicated in (11).

  □ 16-by-1bit table of transfer-trigger type, selectable between software and a dedicated hardware signal, which is one of the trigger(15:0) lines ((14 in Figure 2).

  □ 16-by-1bit table of soft-triggers, used for initiating transfers under software control, when the corresponding entries in the transfer-trigger type table have been set to "soft triggering".

The Address-Generator tables appear to the programmer as an array of packed attributes, indexed by channel, as shown in (17). The Prioritizer Logic (10) implements the round-robin TDM algorithm to swap bus access among the pool of active channels, i.e. the subset of the DMA-engine's channels that have been activated (or "triggered") to perform memory transfers. The indication for active/idle channel is coded in a 16-deep array of single-bit semaphores. A semaphore set to '1' corresponds to an active channel. A semaphore is set (or equivalently, the associated channel is triggered) either by a system processor writing to an entry of the soft-trigger table (20) or by a system peripheral placing an appropriate signal onto the corresponding wire from the set of trigger lines (14), associated with that channel. Once a semaphore is set, it remains so until the programmed transfer is completed or an error condition occurs during the transfer, whereby the channel is removed from the active pool. A set semaphore can only be cleared by the host(s) performing a soft-reset on the DMA Engine as discussed in the description of the Access-Control (15), whereby all transfer activity ceases and the DMA Engine is left idle and empty of all programming. An attempt to soft-trigger a channel that is already active with a transfer results in an bus-error indication to the initiating host, the associated semaphore remains set and the transfer continues as normal. An attempt by a system peripheral to re-trigger an active channel via its dedicated trigger line (14) is silently ignored by the DMA-Engine.

- **The Interrupt-Vector Generator (11)** drives the irq_0 and irq_1 lines (13) that are attached to as many hosts, in order to alert said hosts to channel termination events. It also contains two queues, onto which an IRQ-vector is placed each time a transfer completes or defaults and a channel is removed from the active pool. The act of placing an IRQ-vector at the end of a queue raises the corresponding hardware signal (irq_0 for queue #0 and irq_1 for queue #1). Either of the irq_0, irq_1 signals remains raised for as long as the corresponding queue contains IRQ-vectors that have not been read by the host to which that queue is attached. Each queue is capable of holding up to eight 8-bit interrupt-vectors, generated by the Acorn DMA engine, according to the IRQ mask of the transfer descriptor (17) programmed in the channel causing the interrupt. Each 8-bit IRQ-vector holds information on transfer status, such as the index of the channel that caused the interrupt, the cause of the interrupt (i.e. whether it is normal transfer completion or channel was removed from the active pool due to mis-programming, or a bus-error occurred during a transfer) and the number of entries already in the queue when the interrupt was issued. The availability of a queue for IRQs allows the DMA-Engine to continue with other transfers, without waiting for the system processor to acknowledge the IRQ generated when a particular transfer ends because, as long as there is space in the queue where an IRQ-vector is to be placed, the engine does not need to stop transferring data. We employ two queues that can hold a maximum of eight IRQ-vectors before the engine is forced to stall, because there is no place to retain information on the cause of interrupt. Two queues were adopted for the Acorn DMA Engine, so that up to two different processors can be interrupted with indications of transfer terminations. The signals irq_0, irq_1 of item (13) are the "empty" indicators of the corresponding queues of IRQ-vectors. An '1' appearing on either wire means that the associated queue is not empty, i.e. there is at least one IRQ-vector to be read by the system processor(s) attached to the interrupt wire. The Interrupt-Vector Generator (11) contains specialized hardware that en-queues IRQ-vectors, de-queues said vectors each time the associated host reads the queue of said vectors and halts DMA operation if either of the two queues becomes full before the associated host has the time to take entries of said queue.

- **The Main Controller (12)** is the unit that coordinates all other functional units and handshakes with the system bus via the AHB bus-master interface. It is realized in hardware for maximum speed.
- **The Access-Control (15)** houses two registers; one is employed for clearing the DMA Engine of all programming under software control. This soft-reset action is taking place whenever a system host writes an arbitrary value to the soft-reset register. The other register is employed for bringing the DMA-Engine into and out-of test-mode, for diagnostic purposes. While in test-mode, the DMA-Engine performs no transfers and all information stored inside the DMA as in (16),(17),(19),(21) and (22) are accessible via the AHB slave interface that connects the DMA-Engine to the system bus. A 64-character identification string is also part of the Access-Control, stored in a 64-by-8-bit ROM. Said identification string may be used to hold a product or version reference designator.

All the structures indicated in Figure 3 are accessible to the system programmer, by mapping them onto an 1-kbyte address-space, which can be placed anywhere within the System Address-Space. A software-driver has been developed in 'C', for use by the System's programmer. The Acorn DMA is seen via the software API as a single 'C" structure that contains unsigned integer and byte-arrays of fixed length, corresponding to the DMA-Engine's internal storage for transfer-programming (16), channel-attributes (17), transfer-context (21), IRQ-vector queues (18) and access control registers (19).
There are two types of errors that are trapped by the Acorn DMA Engine:

a) Bad transfer specification: A specification was given for a block of zero bytes, or a scatter-gather list with null pointer, or one that is not aligned to a word boundary in System Memory. In these cases, the channel is removed immediately from the active pool, and an IRQ is dispatched to the processor mapped on that channel.
b) DMA panic due to bus-error during a transfer: An IRQ-vector is placed at the end of queue #0, signaling that a bus-error has occurred. This action is accompanied by the removal of all channels from the active pool and loss of any data waiting to be dispatched from the data-buffer.

The drawing of Figure 4 shows a flow-chart (23) of DMA operation. Activity can be described in terms of a main loop for active channel rotation, incorporating two smaller loops that carry-out the read and write phases of the TDM slot allocated to each channel.
The end of the read phase of a slot is signaled by the timeout of a counter loaded with the channel TDM slot-width value at the beginning of the slot, or alternatively by a flag, which is signaling that the current block has been read completely. End of the write phase for the slot is signaled by the emptying of the internal data-buffer, which may take a different number of bus cycles from the preceding read-phase.
Upon end of slot (either due to slot-counter timeout, or block-end), if the current block has finished and a single block transfer had been programmed for the channel, it is removed from the pool of active channels. The channel is likewise removed if this was the last block moved for a multi-block transfer request, otherwise a block-counter is updated and the channel remains in the active pool.
If the requested transfer is a scatter-gather, the link-pointer is checked for termination (i.e. null value); if not null, the pointer is de-referenced and the channel remains in the active pool. The de-reference algorithm ends by reading-in the next value to be stored in the Link-Pointer entry for the channel. If the link-pointer was null, no de-reference is performed, and the channel is removed from the active pool.
After the above checks and actions have been performed at the end of the TDM slot, the next active channel is brought-in and the above steps are repeated. The process continues until no channels are left in the active pool. If there is a group P of active channels that have their privilege flag (17) set and another group N of active channels with said flag cleared, then the algorithm (23) is applied first to group P and subsequently to group N. Within each group, the round-robin TDM algorithm is apportioning time to each active channel, based on the P_width value of table (17). Each active channel i therefore sees a system bus with an effective bandwidth $B_{eff}(i)$ given by the following formula:

$$B_{eff}(i) = B_{nom} \times \frac{P\_Width(i)}{\Sigma P\_width(j),} \qquad (24)$$

where $B_{nom}$ is the nominal system bus bandwidth as seen by the DMA-Engine, i can assume any value from 0 to 15 and j are the indices of all active channels, including channel i. The value given by formula (24) is updated each time a channel is added or removed to the active pool. The round-robin TDM algorithm, coupled with the bus-sharing formula (24) improve system dynamics, because: a) An activated channel starts transferring data right away, thus giving the opportunity to the system-task associated with the transfer to begin data-processing immediately and b) The priority value P_Width of channel-attribute (17) given to each active channel means that time-critical data-transfers use a larger percentage of the available bus-bandwidth and get to finish faster, compared to less urgent tasks.

The flow-chart (23) of Figure 4 does not depict segregation of channel service, i.e. the fact that all privileged and active channels are serviced as a group ahead of all other active, but non-privileged channels. Note also that (24) applies to each group of active channels separately, i.e. indices j only include privileged- and non-privileged channels accordingly.

**Keywords and Abbreviations**

**AHB:** Amba High-Performance Bus. An embedded bus standard proposed by ARM Ltd.
**API:** Applications Programming Interface. Generic description of sets of computer programs and data-structures which act as the medium via which an applications programmer accesses the capabilities of a hardware component that is part of a computer system.
Arbiter: A component of a bus-based system, which is responsible for granting the bus to one out of a number of requiesting masters.
**ASIC**: Application-Specific Integrated Circuit. A custom-fabricated IC, that may incorporate standard components, which has a fixed function that cannot be modified by means of, e.g. software. ASICs are frequently used for demanding applications that cannot be served by ordinary processor-based systems.
Bus: A method for interconnecting components in a computer system, whereby a set of wires and circuits is shared under a commonly agreed access method, called a "bus protocol", by all components attached to said set. Such components might be processors, DMA engines, memories or other peripherals.
**DMA:** Direct Memory Access. Method for performing data-transfers in a bus-based system, whereby data are transferred to/from memory under control of dedicated hardware, without involvement of the system processor.
**FIFO:** First-In-First-Out. Generic designation of a data-structure, whereby data items are entered at the back of a queue and are removed from the front of the queue, thereby preserving the order of data movement.
**FPGA:** Field-Programmable Gate-Array. A special type of integrated circuit, which can be internally programmed to emulate the behaviour of a specific digital circuit. FPGAs can be reprogrammed to emulate different circuits by means of specialized software alone, without modifications required to their hardware structure, making them very useful for rapid prototyping of circuits and systems.
**IC:** Integrated Circuit. A complex circuit, employing a large number of discrete elements, fabricated on a single piece of silicon.
**IRQ:** Interrupt ReQuest. A mechanism for signalling a particular event to a controller such as a processor asynchronously, i.e. without the signalled agent needing to monitor for said signall and thus wasting time or performance. Upon reception of an IRQ, the processor executes a brief program in order to respond to the causing event.
**ROM**: Read-Only-Memory. Computer memory, the contents of which cannot be modified and is frequently employed for storing permanent system parameters/attributes or program codes for executing a fixed function.
**Slot:** The amount of contiguous time allocated at a time to an agent that is sharing a resource under a *TDM* algorithm.
**SRAM:** Static Random-Access-Memory. Computer memory, which allows writing and reading of arbitrary data values into any of the available storage positions irrespective of the sequence of access. The particular type of memory retains the contents of a location in between two write accesses indefinitely, for as long as electric power is applied.
**Synthesizable:** Code written in a suitable high-level language in such a manner as to allow translation of said code into a hardware circuit of equivalent behaviour, in an accurate and easily reproducible manner.
**TDM:** Time-Division Multiplexing. An algorithm for sharing a common resource among a number of agents, whereby access to the shared resource is allocated for a limited amount of time (called a *slot*) before it is turned over to another requesting agent.
**VHDL:** Very-High-Speed-Circuit-Design-Language. A high-level computer language, broadly used for the description and modelling of digital electronic circuits. Code written in VHDL can be read by synthesis tools to render circuits that realize the behaviour described by said code.

**Claims**

1. Acorn DMA Engine apparatus designed for use with a single 32-bit AHB Bus for embedded systems, capable of achieving very high data - transfer rates across the system's bus with a minimum of main processor involvement, said DMA Engine employed in a bus-oriented computer system performing transfers of data within system memory, said engine capable of offloading simple repetitive task from the system's processor, said engine typically configured as a bus master that negotiates possession of system bus with an arbiter, said engine allows programming a number of channels with the characteristic of individual memory-to-memory transfers and controlling the onset of these transfers, said engine can be embedded into an ASIC or FPGA, said engine improves system dynamics by serving all channels concurrently by allocating time on the system-bus with a round robin TDM algorithm, said channels can be dynamically reprogrammed and/or activated while other active channels are being serviced, without introducing interruptions to data-transfers taking place over the bus, size of said data-transfers is adjusted on a per-cycle basis minimizing total transfer time, even for transferring data that is not aligned on maximum bus-width word boundaries, said ACORN DMA Engine developed for incorporation into systems based on the Amba-High-Performance-Bus (AHB), said ACORN DMA engine comprising a) 16 hardware channels for DMA transfers b) transfer characteristics individually programmable per channel c) one of three transfer modes individually selectable per channel d) capability of addressing FIFOs or other types of I/O devices as if they are ordinary memory e) automatic adjustment of data-transfer size irrespective of address-alignment f) two hardware queues for holding IRQ-vectors.

2. Acorn DMA Engine apparatus according to claim 1, where bus bandwidth is allocated to active channels, ranging from 0 to 15 with a round-robin TDM algorithm, on the basis of a programmable, two-tier priority scheme, said scheme segregating active channels in high-priority and low-priority groups, so that high-priority transfers finish ahead of low-priority transfers, said groups serviced with said round-robin TDM algorithm.

3. Acorn DMA Engine apparatus according to claims 1 and 2, where said channels can be programmed to issue an interrupt to either of two system hosts at the end of a programmed transfer, or upon detection of an error condition related to the transfer.

4. Acorn DMA Engine apparatus according to claims 1 through 3, where said interrupts are placed in either of two queues of fixed length, one queue per host, said queues allowing continuation of DMA transfers even while other interrupts are still pending for service by the system host(s).

5. Acorn DMA Engine apparatus according to claims 1 through 4, where said channels are capable of three transferring modes, said modes being single-block, multiple-block and scatter-gather, which is a list of consecutive single-block or multiple-block transfers.

6. Acorn DMA Engine apparatus according to claims 1 through 4, where single and multiple-block transfers are re-triggerable without requiring channel programming.

7. Acorn DMA Engine apparatus according to claims 1 through 5, where said engine is capable of accessing FIFO and other types of I/O devices which are mapped onto a single system-address-location, said devices capable of transmitting/receiving multiple data words to said system.

8. Acorn DMA Engine apparatus according to claim 1 where transfers can be programmed to be triggered either by software executed by the system hosts, or by system slaves via dedicated trigger lines that are not part of the system-bus.

9. Acorn DMA Engine apparatus according to claim 1 where data-transfer size is automatically adjusted on a per-bus-cycle basis, said adjustment resulting in minimization of total transfer-time. 10.Acorn DMA Engine apparatus according to claim 1, where said DMA Engine features one 32-bit Amba - High - Performance - (AHB) slave port for channel programming and diagnostic purposes and one 32-bit AHB master port for bus arbitration and control when said DMA Engine is servicing an active transfer. 11.Acorn DMA Engine apparatus which includes a variety of systems according to any of the claims from 1 to 10.

Figure 1: System-level view of memory-transfers mediated by the Acorn DMA core.

Figure 2: The DMA-Engine's block-diagram. Note that the indicated "AHB Bus", "Slave Bus Interface & Address Decoder" and "Master Bus Interface" blocks are not the subject of this description and are not covered by this patent claim.

Channel Attributes

| 15 | | | | |
|---|---|---|---|---|
| | | . | | 17 |
| | | . | | |
| Ch. #i | Trigger_Control | IRQ_map | Privilege | P_Width |
| | | . | | |
| | | . | | |
| 0 | | . | | |

Soft Triggers

| 15 | |
|---|---|
| | . |
| | . |
| Ch. #i | S_Trigger |
| | . |
| | . |
| 0 | . |

**20**

Signature Block

| Test-mode | ID string (64 char) |
|---|---|
| soft-reset | |

**19**

IRQ-Vector Queues

| #0 | #1 |
|---|---|

**18**

Transfer Descriptors

| 15 | | | | | | | | | | |
|---|---|---|---|---|---|---|---|---|---|---|
| | | | | . | | | | | | 16 |
| Ch. #i | Source | Destination | Block Size | Block Cnt | Src Stride | Dst Stride | src_fix | dst_fix | Mode | IRQ mask |
| | | | | | . | | | | | |
| | | | | | . | | | | | |
| 0 | | | | | . | | | | | |

Transfer Context

| 15 | | | | | |
|---|---|---|---|---|---|
| | | | . | | |
| Ch. #i | Block Offset | Curr. Block | Source Stride Offset | Dest. Stride Offset | Link-Pointer |
| | . | | | | |
| | | | . | | |
| | | | . | | 22 |
| 0 | | | | | |

Data Buffer

**21**

16x32-bit

Accessible in test-Mode Only

Figure 3: The Acorn DMA programming model.

Figure 4: Basic flowchart of Acorn DMA operation.